# EUROPÄISCHE PATENTSCHRIFT

(11) **EP 1 982 203 B1**
(45) Veröffentlichungstag und Bekanntmachung des Hinweises auf die Patenterteilung: **30.11.2011**
(21) Anmeldenummer: 07703071.6
(22) Anmeldetag: 26.01.2007
(51) Int. Cl.: G01R 31/28, G01R 31/309

(54) **Verfahren und Vorrichtung zum Testen von unbestückten Leiterplatten**
Method and device for testing bare circuit boards
Procédé et dispositif pour tester des cartes de circuits imprimés nus

(30) Priorität: 08.02.2006 DE 102006005800
(43) Veröffentlichungstag der Anmeldung: 22.10.2008
(73) Patentinhaber: DTG International GmbH, 8005 Zürich (CH)
(72) Erfinder: ROMANOV, Victor, 97877 Wertheim (DE); ROTHAUG, Uwe, 97828 Marktheidenfeld (DE)
(74) Vertreter: Ganahl, Bernhard
(86) Internationale Anmeldenummer: PCT/EP2007/000690
(87) Internationale Veröffentlichungsnummer: WO 2007/090528

(56) Entgegenhaltungen:
- WO-A-01/91053
- WO-A-03/096037
- DE-A1- 4 134 193
- DE-A1- 19 703 982
- CHESTNEY J A ET AL: "CONTROL AND INTEGRATION TECHNIQUES IN A FULLY AUTOMATED MANUFACTURING CELL FOR CARBON COMPOSITES" IEE PROCEEDINGS: CONTROL THEORY AND APPLICATIONS, IEE, STEVENAGE, HERTS, GB, Bd. 143, Nr. 2, 1. März 1996 (1996-03-01), Seiten 159-163, XP000592314 ISSN: 1350-2379

## Beschreibung

Die vorliegende Erfindung betrifft ein Verfahren und eine Vorrichtung zum Testen von unbestückten Leiterplatten.

Prüfvorrichtungen zum Testen von Leiterplatten können grundsätzlich in zwei Gruppen eingeteilt werden, den Fingertestem und den Paralleltestern. Die Paralleltester sind Prüfvorrichtungen, die mittels eines Adapters alle oder zumindest die meisten Leiterplattentestpunkte einer zu prüfenden Leiterplatte gleichzeitig kontaktieren. Fingertester sind Prüfvorrichtungen zum Testen von unbestückten oder bestückten Leiterplatten, die mit zwei oder mehreren Prüffingern die einzelnen Kontaktstellen sequentiell bzw. seriell abtasten. Das serielle Testen mit einem Fingertester ist prinzipbedingt langsamer als das parallele Testen mit einem Paralleltester.

Die Prüffinger sind in der Regel an einem Schlitten befestigt, welcher entlang von Traversen verfahrbar ist, wobei die Traversen wiederum auf Führungsschienen geführt und verfahrbar sind. Die Schlitten können somit an jede beliebige Stelle eines in der Regel rechteckförmigen Prüffeldes positioniert werden. Gleichermaßen gibt es Prüfvorrichtungen mit ortsfesten Traversen, an welchen Schlitten verfahrbar ausgebildet sind. An diesen Schlitten sind Prüffinger angeordnet, die eine gewisse Länge aufweisen und an einem Ende schwenkbar am Schlitten befestigt sind. Durch die Schwenkbewegung des Prüffingers kann ein gewisser Bereich quer zur Traverse abgetastet werden. Mit beiden Typen von Fingertestem können alle Leiterplattentestpunkte einer zu prüfenden Leiterplatte kontaktiert und damit getestet werden.

Ein Fingertester ist in der EP 0 468 153 A1 und ein Verfahren zum Prüfen von Leiterplatten mittels eines Fingertesters ist in der EP 0 853 242 A1 beschrieben.

Das wesentliche Kriterium um Fingertester am Markt erfolgreich durchsetzen zu können, ist die Geschwindigkeit, mit welcher eine zu prüfende Leiterplatte getestet werden kann. Um diese Prüfgeschwindigkeit zu beschleunigen sind bereits spezielle Prüfverfahren (z. B. EP 0 853 242 A1 bzw. die korrespondierende US 5,977,776) oder spezielle Prüfsonden (z. B. US 5,804,982 bzw. US 6,344,751) entwickelt worden. Eine solche Prüfsonde zum schnellen Kontaktieren eines Leiterplattentestpunktes einer zu testenden Leiterplatte geht aus der US 5,113,133 hervor.

Aus der WO 92/11541 geht ein Bildgewinnungssystem für eine Vorrichtung zum Testen von Leiterplatten hervor. Dieses Bildgewinnungssystem weist ähnlich wie bei einem X-Y-Schreiber eine verfahrbare Traverse auf, auf welcher ein Prüfkopf mit einer vertikal beweglichen Prüfnadel angeordnet ist. Neben der Prüfnadel ist eine Kamera bestehend aus einer Linse und einem CCD-Element angeordnet. Das von der Kamera erzeugte Bild wird auf einem Monitor dargestellt. Ein Bediener kann anhand des am Bildschirm dargestellten Bildes den Prüfkopf derart steuern, dass er während einer Lemphase alle zu testenden Kontaktpunkte abfährt und die entsprechenden Koordinaten programmiert. Während des Tests fährt die Vorrichtung selbsttätig die einzelnen Kontaktpunkte ab und kontaktiert sie mit der Prüfnadel.

Mit dieser bekannten Vorrichtung wird somit mit Hilfe einer Kamera die Bewegung der Kontaktfinger bezüglich einer Leiterplatte gelernt. Bei aktuellen Leiterplatten ist dies praktisch nicht mehr möglich, da die Leiterplatten so viele Leiterplattentestpunkte aufweisen, die jeweils mit einem Kontaktfinger kontaktiert werden müssen, dass ein solcher Lernvorgang weder mit einem wirtschaftlich vertretbaren Zeitaufwand durchgeführt werden kann, noch aufgrund des Umfangs der Anzahl der Kontaktvorgänge es praktisch nicht möglich ist, dies fehlerfrei auszuführen. Deshalb werden bei aktuellen Fingertestem die Prüffinger anhand von CAD-Daten der zu testenden Leiterplatte gesteuert. Für diese CAD-Daten gibt es unterschiedliche Formate. Das am weitesten verbreitete Format sind die sogenannten Gerber-Daten.

Damit die Positionierung der Prüffinger korrekt ausgeführt werden kann, sind bei aktuellen Fingertestem vor dem eigentlichen Prüfen der zu prüfenden Leiterplatte zwei Kalibriervorgänge auszuführen. Bei einem ersten Prüfvorgang werden die Prüfköpfe, die jeweils aus einem Schlitten und einem Kontaktfinger ausgebildet sind, bezüglich der Prüfvorrichtung kalibriert und in einem zweiten Kalibriervorgang werden die CAD-Daten einer zu testenden Leiterplatte in Übereinstimmung mit einer tatsächlichen Leiterplatte, die in die Prüfvorrichtung eingelegt ist, gebracht.

Beim ersten Kalibriervorgang wird in die Prüfvorrichtung eine Kalibrierplatte eingelegt, die eine großflächige Leiterplatte ist, auf welcher mittels der Leiterbahnen ein Gitter auf der Oberfläche der Leiterplatte ausgebildet ist. Mit den Kontaktfingern werden die Kreuzungspunkte des Gitters kontaktiert. Anhand dieser Kontakte kann die jeweilige Position der Kontaktfinger ermittelt und die Prüfvorrichtung kalibriert werden.

Der zweite Kalibriervorgang wird in der Regel für jede zu prüfende Leiterplatte ausgeführt. Hierbei wird eine Leiterplatte einer Charge in die Prüfvorrichtung eingelegt und dann werden mittels der Prüffinger oder mittels einer über der Leiterplatte beweglichen Kamera markante Leiterplattentestpunkte des Musters der zu testenden Leiterplattentestpunkte detektiert und deren Lage in der Prüfvorrichtung bestimmt. Sind die Leiterplattentestpunkte erfasst, so können die CAD-Daten der Leiterplattentestpunkte der zu testenden Leiterplatte in Übereinstimmung mit den Koordinaten der physikalischen Leiterplatte gebracht werden, d.h., dass die für eine Charge typischen Verzüge und Versätze des Musters der Leiterplattentestpunkte erfasst und abgespeichert werden.

Sind beide Kalibriervorgänge durchgeführt, so können die Leiterplattentestpunkte der zu testenden Leiterplatte erfolgreich angesteuert und mittels der Prüffinger kontaktiert werden.

Aus der WO 03/096037 geht ein Verfahren hervor, bei dem die Kontaktspitzen während des Prüfvorganges mittels einer optischen Detektionseinrichtung überwacht und deren Bewegung zumindest beim Anfahren eines Teils der Leiterplattentestpunkte einer zu testenden Leiterplatte mittels des von der optischen Detektionseinrichtung ermittelten Ergebnisses derart automatisch korrigiert werden, dass die Kontaktspitze sicher und mit den jeweiligen Leiterplattentestpunkt kontaktiert wird. Hierdurch werden Leiterplattentestpunkte exakt kontaktiert, selbst, wenn die entsprechenden Positionierdaten noch nicht kalibriert oder noch nicht exakt kalibriert sind.

Aus den sich hierbei ergebenden Korrekturdaten können Kalibrierdaten berechnet werden. Diese Kalibrierdaten ersetzen die beiden bei herkömmlichen Fingertestem üblichen Kalibriervorgänge, da sie die örtliche Relation zwischen den Kontaktspitzen der Prüffinger und den physikalischen Leiterplattentestpunkten der zu testenden Leiterplatten eindeutig festlegen.

Weiterhin ist aus der DE 42 21 075 A1 bzw. der korrespondieren US 5,596,283 ein Testverfahren für Leiterplatten bekannt, bei welchen ein Fingertester mit einer Einrichtung zum Ausrichten der Leiterplatte gegenüber dem Messsystem versehen ist. Diese Ausricht-Einrichtung weist eine Kamera zum Detektieren der Leiterplatte auf. Hiermit werden vorbestimmte Schaltungsbestandteile bzw. Strukturen über Leiterbahnen und Anschlüsse auf der Oberfläche der Leiterplatte gesucht. Diese Merkmale bzw. Bestandteile der Leiterplatte werden automatisch lokalisiert und eine Ausrichtungstransformation zwischen dem Koordinatensystem der Leiterplatte und dem Koordinatensystem des Bewegungssystems wird durchgeführt.

Mit diesen bekannten Systemen wird somit eine exakte Positionierung der Prüffinger bezüglich der Leiterplattentestpunkte erzielt.

Aus der DE 197 03 982 A1 ist ein Verfahren zum Prüfen von Leiterplatten bekannt, das mit einem Fingertester ausgeführt wird. Nach dem Einlegen einer zu prüfenden Leiterplatte in den Fingertester wird die Leiterplatte optisch abgetastet und das Muster von auf der Leiterplatte angeordneten Prüfpunkten erfasst. Es wird eine Abweichung gegenüber einer idealen Leiterplatte, die ideal in die Prüffinger eingelegt ist, ermittelt und ein Koordinatensystem des Fingertesters nach Maßgabe der ermittelten Abweichung korrigiert. Die Prüffinger des Fingertesters werden nach dem korrigierten Koordinatensystem verfahren.

Trotz dieser automatischen Kalibrierverfahren ist es immer noch notwendig, die Daten zum Ansteuern der Prüffinger manuell zu korrigieren. Eine solche manuelle Korrektur ist erforderlich, da die tatsächlich zu prüfenden Leiterplatten nicht nur Abweichungen der Ist-Position der einzelnen Leiterplattentestpunkte gegenüber ihren von den CAD-Daten vorgegebenen Soll-Positionen aufweisen, sondern die einzelnen Leiterplattentestpunkte manchmal auch mit unterschiedlicher Form oder in unterschiedlicher Art (Pad-Feld bzw. Durchkontaktierung) gegenüber den CAD-Daten ausgeführt sind. Dies ist ein Problem, das zumindest schon so lange besteht, wie mehrlagige Leiterplatten hergestellt werden. Denn beim Herstellen von mehrlagigen Leiterplatten werden die ursprünglichen CAD-Daten, die die gesamte Leiterplatte definieren in mehrere separate Konstruktionszeichnungen für die einzelnen Lagen umgesetzt. Diese Konstruktionszeichnungen für die einzelnen Lagen werden oftmals in einem anderen Datenformat als die die gesamte Leiterplatte beschreibenden CAD-Daten erstellt. Bei entsprechenden Datentransformationen können Ungenauigkeiten entstehen. Zudem werden von den Fertigungsspezialisten manchmal auch Änderungen vorgenommen, bei denen beispielsweise SMD-Pads durch Durchkontaktierungen und umgekehrt, ersetzt werden, um die Fertigung einer Leiterplatte zu vereinfachen. Diese Änderungen finden jedoch in der Regel keinen Eingang in die die gesamte Leiterplatte beschreibenden CAD-Daten. Weiterhin wird aus fertigungstechnischen Gründen manchmal das Muster, mit welchen ein Lötstopplack auf den einzelnen Lagen aufgebracht wird, geändert. Dies kann beim Testen von Leiterplatten insbesondere dann Auswirkungen haben, wenn Lötstopplack der äußeren Oberfläche einer Leiterplatte verändert wird, denn dann werden hierdurch auch die Formen der einzelnen Leiterplattentestpunkte, insbesondere der Pad-Felder, geändert. So kommt es manchmal vor, dass rechteckige SMD-Pad-Felder in kreisförmige SMD-Pad-Felder oder langgestreckte streifenförmige z.B. in quadratische SMD-Pad-Felder geändert werden.

Diese Abweichungen eines konkreten zu testenden Leiterplattentyps gegenüber den entsprechenden CAD-Daten machen es notwendig, die Steuerungsdaten eines Fingertesters für einen jeden Typ von Leiterplatten bzw. für eine jede Charge von Leiterplatten manuell abzugleichen.

In der Praxis wird zunächst ein Testvorgang ohne manuellen Abgleich durchgeführt. Wenn Problemen auftreten, was meistens der Fall ist, werden die Problemstellen manuell identifiziert und entsprechend korrigiert. Bis alle Problemstellen behoben worden sind, muss dieser Vorgang mehrfach wiederholt werden. Dies kann je nach Komplexität des Leiterplattentyps mehrere Stunden bis zu einem Tag dauern. Wenn anstelle von Pad-Feldem Durchkontaktierungen an einer Leiterplatte ausgebildet sind, kann es zudem passieren, dass ein Prüffinger mit seiner aus dünnem Draht ausgebildeten Kontaktspitze in diese Durchkontaktierung einfährt und bei einer weiteren seitlichen Bewegung des Prüffingers abgerissen wird. Dies führt dann zu einem Ausfall der gesamten Testvorrichtung und erzeugt zusätzliche Materialkosten durch den Austausch der Prüfsonde.

Mit der Erfindung soll ein Verfahren und eine Vorrichtung geschaffen werden, mit welcher die oben beschriebenen Probleme wesentlich vermindert bzw. vollständig beseitigt werden.

Diese Aufgabe wird durch ein Verfahren mit den Merkmalen des Anspruchs 1 und durch eine Vorrichtung mit den Merkmalen des Anspruchs 13 gelöst. Vorteilhafte Ausgestaltungen der Erfindung sind in den entsprechenden Unteransprüchen angegeben.

Das erfindungsgemäße Verfahren zum Testen von unbestückten Leiterplatten umfasst folgende Schritte:
- Erfassen vorbestimmter Bereiche einer zu testenden Leiterplatte mit einem bildgebenden Verfahren,
- Ermitteln von Form und/oder Typ von in den vorbestimmten Bereichen liegenden Leiterplattentestpunkten mittels automatischer Bildanalyse,
- Vergleichen der ermittelten Form und/oder Art der Leiterplattentestpunkte mit entsprechenden CAD-Daten der Leiterplatte und Ermitteln von Abweichungen der zu testenden Leiterplatte von den CAD-Daten, und
- Testen der Leiterplatte mit einem Fingertester, wobei Prüffinger des Fingertesters nach Maßgabe der ermittelten Abweichungen angesteuert werden.

Mit dem erfindungsgemäßen Verfahren werden Abweichungen von den CAD-Daten vor dem eigentlichen Durchführen eines Testvorganges ermittelt. Beim Testen der Leiterplatte mit einem Fingertester werden die Prüffinger nach Maßgabe der ermittelten Abweichung angesteuert, wodurch die oben beschriebenen Probleme vermieden werden. Insbesondere erfolgen keine Fehlkontaktierungen und kein Eintauchen einer Prüfnadel in eine Durchkontaktierung, die zu einer Beschädigung der Prüfnadel führen kann.

Vorzugsweise werden beim Erfassen mit dem bildgebenden Verfahren Bilddaten erzeugt, aus welchen beim Ermitteln von Form und/oder Typ der Leiterplattentestpunkte Bildausschnitte ausgewählt werden, die jeweils einen oder eine vorbestimmte Gruppe von Leiterplattentestpunkten darstellen, so dass die Bildausschnitte mit vorgegebenen Mustern verglichen werden können, wobei anhand des Mustervergleichs der Typ der Leiterplattentestpunkte ermittelt wird.

Nach dem Ermitteln des Typs der Leiterplattentestpunkte kann die Form der Leiterplattentestpunkte durch Analysieren der entsprechenden Bildausschnitte ermittelt werden. Mit dem Begriff Form wird bei dem vorliegenden Verfahren auch die Größe der Leiterplattentestpunkte bezeichnet, die automatisch festgestellt wird.

Vorzugsweise werden die ermittelten Abweichungen verwendet, um die CAD-Daten zu korrigieren, so dass beim Testen der Leiterplatten die Prüffinger anhand der korrigierten CAD-Daten angesteuert werden können.

Das bildgebende Verfahren kann ein optisches Verfahren sein, das mittels eines optischen Sensors, insbesondere einer oder mehrerer Kameras, die Oberfläche der zu testenden Leiterplatte abtastet. Das bildgebende Verfahren kann jedoch auch ein elektromechanisches Verfahren sein, bei welchem die Oberfläche der zu testenden Leiterplatte mit einer derart hohen Auflösung elektrisch abgetastet wird, dass ein Bild der Oberfläche erzeugt wird. Derartige Verfahren sind beispielsweise aus der US 5,625,297 bzw. der DE 40 12 839 B4 oder der EP 0 989 409 A1 bekannt.

Das Erfassen der vorbestimmten Bereiche der zu testenden Leiterplatte mit einem Bild gebenden Verfahren kann innerhalb einer Prüfvorrichtung ausgeführt werden. Hierzu kann jedoch auch eine separate Abtastvorrichtung vorgesehen werden, die vorzugsweise einen handelsüblichen optischen Büro-Scanner umfasst, der mit einer Einrichtung zur automatischen Bildanalyse verbunden ist, mit welcher die Abweichungen von den CAD-Daten ermittelt werden können.

Die Erfindung wird nachfolgend anhand von Ausführungsbeispielen näher erläutert. Die Ausführungsbeispiele sind in den beigefügten Zeichnungen dargestellt. Die Zeichnungen zeigen in:
- Figur 1: eine in einem Fingertester integrierte Vorrichtung zum Ausführen des erfindungsgemäßen Verfahrens mit jeweils einer Kamera zum Abtasten der Ober- bzw. Unterseite einer zu testenden Leiterplatte in einer schematisch vereinfachten Schnittansicht;
- Figur 2: eine in einem Fingertester integrierte Vorrichtung zum Ausführen des erfindungsgemäßen Verfahrens mit mehreren Kameras, die an den Prüfsonden angeordnet sind, in einer schematisch vereinfachten Schnittdarstellung,
- Figur 3: einen Ausschnitt einer zu prüfenden Leiterplatte in einem vergrößerten Darstellung,
- Figur 4a-4e: jeweils Muster für Leiterplattentestpunkte bzw. für vorbestimmte Anordnungen von Leiterplattentestpunkten, und
- Figur 5: das erfindungsgemäße Verfahren in einem Ablaufdiagramm.

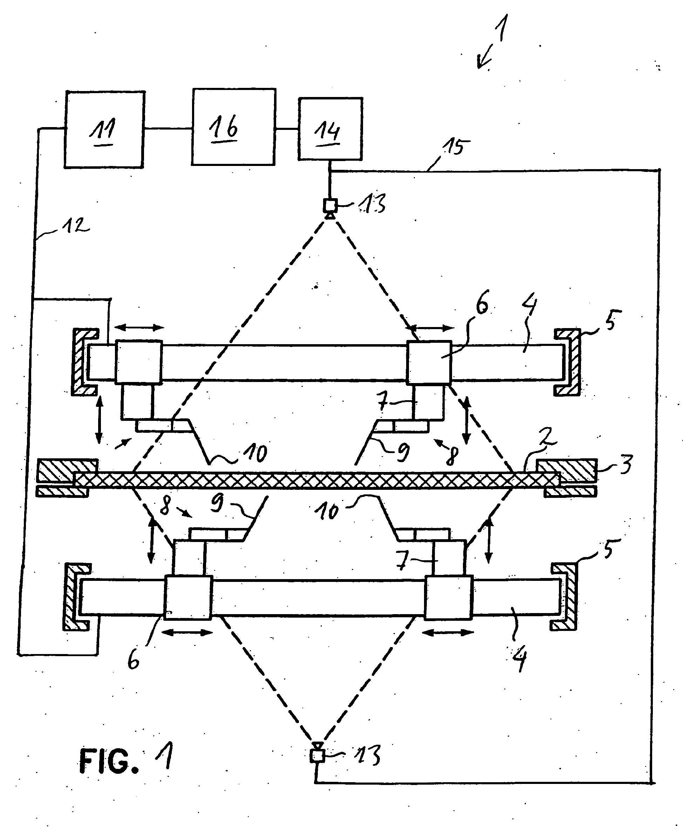

Eine Vorrichtung zum Ausführen des erfindungsgemäßen Verfahrens ist schematisch in Figur 1 gezeigt. Die Vorrichtung ist eine Vorrichtung 1 zum Prüfen von Leiterplatten 2, insbesondere ist diese Vorrichtung ein Fingertester 1. Die zu prüfende Leiterplatte 2 wird von einem Halterrahmen 3 gehalten. Dieser Halterahmen 3 begrenzt einen rechteckigen, ebenflächigen Aufnahmebereich zum Aufnehmen einer Leiterplatte 2. Dieser Aufnahmebereich bildet ein Prüffeld, in dem Leiterplattentestpunkte einer zu prüfenden Leiterplatte kontaktiert werden können. Im Bereich oberhalb und unterhalb des Aufnahmebereichs sind Traversen 4 angeordnet, die sich über den Aufnahmebereich hinweg erstrecken. Vorzugsweise sind oberhalb und unterhalb des Aufnahmebereichs jeweils mehrere Traversen 4 angeordnet, die zueinander parallel ausgerichtet sind. Die Traversen 4 werden mit ihren Enden in Schienen 5 gehalten. Die Schienen 5 verlaufen senkrecht zur Zeichenebene der Figur 1, d.h. senkrecht zu den Traversen 4 bzw. parallel zur Ebene des Aufnahmebereichs. Die Traversen 4 können in den Schienen 5 verfahrbar ausgebildet sein.

An den Traversen 4 sind im vorliegenden Ausführungsbeispiel jeweils zwei Schlitten 6 angeordnet, die entlang der Traversen 4 hin und her verfahren werden können. An die Schlitten 6 ist an der zum Aufnahmebereich zugewandten Seite jeweils ein Prüfkopf 7 angeordnet. An dem zum Aufnahmebereich weisenden Ende des Prüfkopfes 7 ist jeweils eine Prüfsonde 8 angeordnet. Jede Prüfsonde 8 ist mit einer Prüfnadel 9 versehen, die jeweils eine zum Aufnahmebereich weisende Prüfspitze 10 aufweist, mit welcher ein Leiterplattentestpunkt einer zu testenden Leiterplatte 2 kontaktiert werden kann. Der Prüfkopf 7 ist am Schlitten 6 in eine Richtung senkrecht zu der zu prüfenden Leiterplatte 2 bzw. senkrecht zur Ebene des Aufnahmebereiches beweglich ausgebildet. Hierzu kann ein Linearmotor vorgesehen werden, wie er beispielsweise in der deutschen Patentanmeldung DE 101 60 119.0 beschrieben ist. Anstelle des Linearmotors kann prinzipiell auch ein anderer Stellmechanismus verwendet werden. Der Prüfkopf 7 kann auch mit einem Drehmechanismus derart versehen sein, dass die den Prüffinger darstellende Prüfsonde 8 um eine zur Leiterplatte 2 bzw. zur Ebene des Aufnahmebereichs senkrecht stehende Achse geschwenkt werden kann. Bei einer solchen Ausführungsform können die Traversen 4 ortsfest angeordnet sein.

Die Prüfvorrichtung 1 weist eine Steuereinrichtung 11 auf. Die Steuereinrichtung 11 ist über Leitungen 12 mit den Stellgliedern, die sich jeweils aus einem Schlitten 6 und einem Prüfkopf 7 zusammensetzen, verbunden. Die Steuereinrichtung 11 steuert selbsttätig die Bewegung der Stellglieder bzw. der Prüfnadeln 9 zum Kontaktieren von Leiterplattentestpunkten auf einer zu testenden Leiterplatte 2.

Die Prüfvorrichtung 1 weist eine Detektionseinrichtung auf, umfassend zwei Kameras 13 und eine Bilderzeugungseinrichtung 14, die über Leitungen 15 mit den Kameras 13 verbunden ist.

Im vorliegenden Ausführungsbeispiel sind zwei Kameras vorgesehen, wobei eine jede der beiden Kameras 13 eine der beiden Oberflächen der zu testenden Leiterplatte 2 derart zugeordnet ist, dass sie die Oberfläche der Leiterplatte fast vollständig abtasten kann. In der Bilderzeugungseinrichtung 14 werden die Signale der Kameras 13 empfangen und zu Digitalbildem der Oberfläche der Leiterplatte 2 zusammengesetzt.

Die Bilderzeugungseinrichtung 14 ist mit einer Auswerteeinrichtung 16 verbunden, welcher die von der Leiterplatte 2 erfassten Bilder in Form von elektronischen Bilddateien übermittelt werden. In der Auswerteeinrichtung erfolgt eine automatische Bildanalyse der erfassten Bilder zur Erzeugung von Steuerungsdaten für die Steuereinrichtung 11.

Im folgenden Ausführungsbeispiel sind die beiden Kameras 13 ortsfest angeordnet. Nach der Erfindung ist es jedoch auch möglich, anstelle einer ortsfesten Kamera auch eine oder mehrere Kameras vorzusehen, die an den Traversen verschiebbar und unabhängig von den Stellgliedern angeordnet sind, so dass mit der bzw. den Kameras die gesamte Oberfläche der zu testenden Leiterplatte abgefahren und abgetastet werden kann.

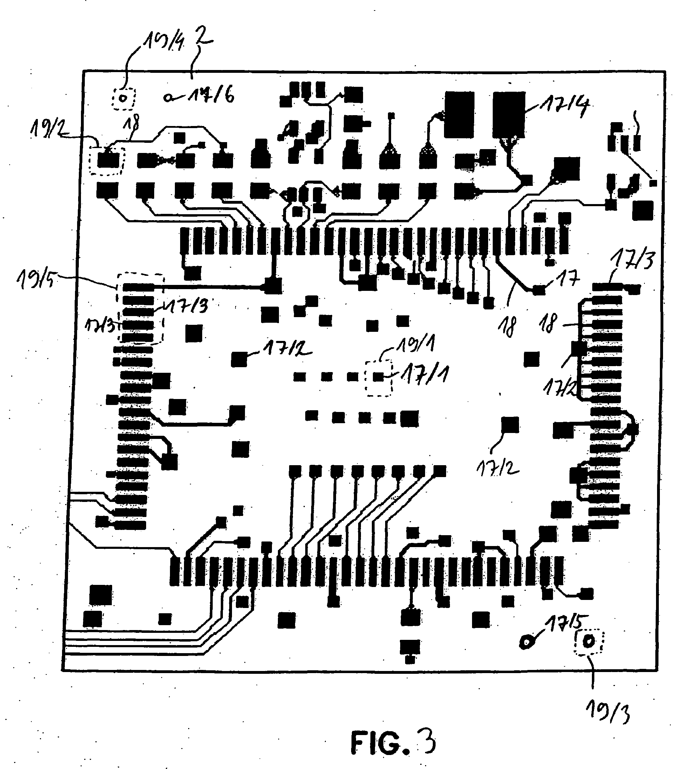

Nachfolgend wird anhand von Figur 3, 4a-4e und Figur 5 die Funktionsweise der erfindungsgemäßen Vorrichtung näher erläutert.

Figur 3 zeigt einen Ausschnitt eines Bildes, das von einer zu testenden Leiterplatte 2 aufgenommen worden ist. Dieser Ausschnitt zeigt Leiterplattentestpunkte 17 unterschiedlicher Art und Form und an der Oberfläche der Leiterplatte 2 verlaufende Leiterbahnen 18. Die Leiterplattentestpunkte sind als Padfelder unterschiedlicher Form und als Durchkontaktierung ausgebildet. So gibt es kleine quadratische Padfelder 17/1, größere quadratische Padfelder 17/2, streifenförmige Padfelder 17/3, großflächige rechteckförmige Padflächen 17/4, Durchkontaktieren mit einem Kupferring 17/5 und Durchkontaktieren ohne Kupferring 17/6. Weiterhin gibt es Padfelder mit der Form eines Kreises oder eines Ovales und es gibt auch rechteckförmige Durchkontaktierungen mit und ohne Kupferring. Weiterhin sind Padfelder in freier Form bekannt, dies gilt insbesondere für größere Padfelder.

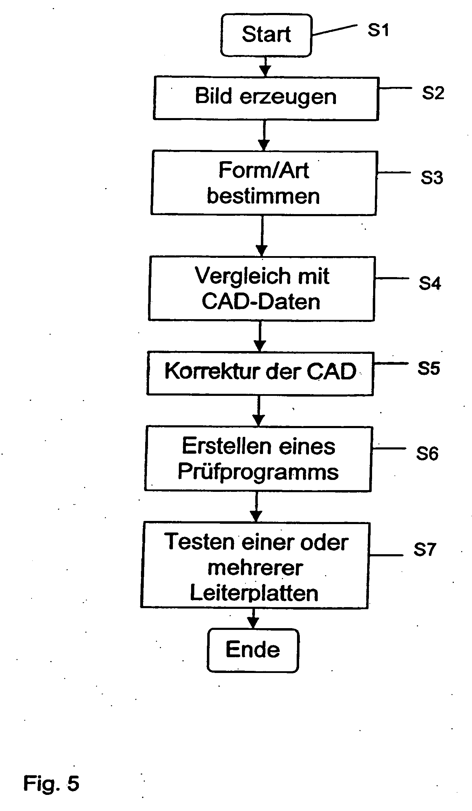

Das erfindungsgemäße Verfahren beginnt mit dem Schritt S1 (Figur 5), nachdem eine Leiterplatte 2, insbesondere die erste Leiterplatte einer Charge von zu prüfenden Leiterplatten bzw. die erste Leiterplatte eines Typs von Leiterplatten, in die Prüfvorrichtung 1 eingelegt ist.

Danach werden mit den Kameras 13 und der Bilderzeugungseinrichtung 14 jeweils ein Bild der beiden Oberflächen der zu testenden Leiterplatte 2 erzeugt (Schritt S2).

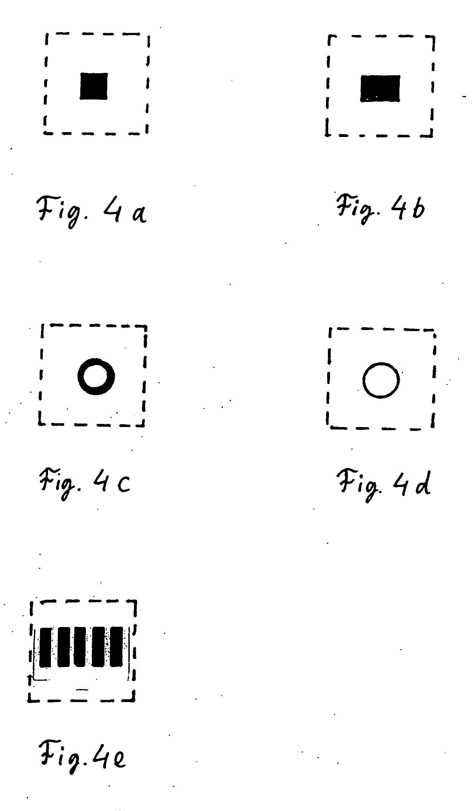

Diese Bilder werden von der Bilderzeugungseinrichtung 14 an die Auswerteeinrichtung 16 übermittelt. In der Auswerteeinrichtung 16 werden die Form und/oder der Typ der einzelnen Leiterplattentestpunkte 17 bestimmt (Schritt S3). Hierzu werden zunächst die Bilder mit einem an sich bekannten Korrelationsverfahren mit den CAD-Daten der zu testenden Leiterplatte derart in Übereinstimmung gebracht, dass anhand der CAD-Daten die Positionen in den Bildern bestimmt sind, an welchen Leiterplattentestpunkte 17 angeordnet sein sollen. An diesen Positionen werden von den Bildern Ausschnitte 19 ausgeschnitten, die auch ein Stück der Umgebung dieser Position beinhalten, so dass bei einer Verschiebung des Leiterplattentestpunktes gegenüber seiner Soll-Position und/oder bei einer Abwandlung seiner Form dieser möglichst noch vollständig im Bildausschnitt 19 enthalten ist. Diese Bildausschnitte 19 werden mit entsprechenden Mustern verglichen. Diese Muster sind jeweils einem Typ von Leiterplattentestpunkten zugeordnet, so dass bei Übereinstimmung eines Musters mit einem Bildausschnitt 19 der entsprechende Typ des Leiterplattentestpunktes bestimmt ist. So stimmt zum Beispiel der Bildausschnitt 19/1 mit dem in Figur 4a gezeigten Muster überein, das dem Leiterplattentestpunkt des Typs quadratisches Padfeld zugeordnet ist. Der Bildausschnitt 19/2 stimmt im Wesentlichen mit dem Muster aus Figur 4b überein, wobei das Vergleichsverfahren, das beispielsweise ein Korrelationsverfahren oder ein Pruning-Verfahren ist, gewisse Abweichung, die zum Beispiel durch kurze Leiterbahnsegmente vorgenommen werden, toleriert.

Der Bildausschnitt 19/3 stimmt mit dem Muster aus Figur 4c überein, der einer Durchkontaktierung mit Kupferrand zugeordnet ist. Der Bildausschnitt 19/4 stimmt mit dem Muster nach Figur 4d überein, der einer Durchkontaktierung ohne Kupferrand zugeordnet ist. Auf diese Art und Weise können die Typen der einzelnen Leiterplattentestpunkte identifiziert werden.

Ein solcher Bildausschnitt kann einen oder mehrere Leitenplattentestpunkte umfassen. So weist der Bildausschnitt 19/5 eine Reihe von streifenförmigen Leiterplattentestpunkten 17/3 auf. Dieser Bildausschnitt stimmt mit dem Muster aus Figur 4e überein. Hierdurch wird der Typ von mehreren Leiterplattentestpunkten gleichzeitig identifiziert. Auf diese Weise wird eine vorbestimmte Auswahl von Leiterplattentestpunkten identifiziert. Nachdem der Typ der einzelnen Leiterplattentestpunkte bestimmt ist, können deren Form nochmals näher analysiert und insbesondere die Größe der Leiterplattentestpunkte bestimmt werden.

Im nächsten Schritt (S4) werden die derart identifizierten Leiterplattentestpunkte mit den CAD-Daten verglichen. Hierbei werden Abweichungen registriert.

Sobald alle Abweichungen ermittelt worden sind, werden die CAD-Daten gemäß den registrierten Abweichungen korrigiert (Schritt S5), sofern die Abweichungen innerhalb eines vorbestimmten Toleranzbereiches liegen. Ansonsten wird das Verfahren angehalten und eine Fehlermitteilung ausgegeben.

Die korrigierten CAD-Daten werden dann an die Steuereinrichtung 11 übermittelt. Die Steuereinrichtung 11 berechnet ein Prüfprogramm (Schritt S6), in dem festgelegt ist wann welcher Leiterplattentestpunkt der zu testenden Leiterplatte mit welchem Prüffinger kontaktiert wird, wobei auch der Ort des Kontaktierungsvorgangs hierin festgelegt ist.

Die Steuereinrichtung 11 steuert die Bewegung der Stellglieder bzw. der Prüfnadel 9 anhand dieses neu berechneten Prüfprogrammes beim Testen der zu testenden Leiterplatte (Schritt S7). Dieses so erstellte Prüfprogramm wird zum Testen mehrerer Leiterplatten, insbesondere aller Leiterplatten einer Charge bzw. aller Leiterplatten eines Typs, verwendet. Die Steuerung der Stellglieder bzw. der Prüfnadel 9 erfolgt somit nach Maßgabe der korrigierten CAD-Daten. Dieses anhand der korrigierten CAD-Daten erstellte Prüfprogramm wird zum Testen aller Leiterplatten einer Charge bzw. aller Leiterplatten eines Typs von Leiterplatten verwendet.

Anstelle des Berechnens eines neuen Prüfprogramms ist es auch möglich, anhand der registrierten Abweichungen eine Korrekturdatei zu erstellen, die einem aufgrund der ursprünglichen, nicht korrigierten CAD-Daten erstellten Prüfprogramm hinzugefügt wird. Dieses Prüfprogramm bezieht dann bei der Steuerung der Stellglieder bzw. Prüfnadel 9 diese Korrekturdatei mit ein, so dass die Ansteuerung der Prüffinger des Fingertesters nach Maßgabe der ermittelten Abweichungen erfolgt.

Das Verfahren ist oben anhand einer Ausführungsform erläutert worden, bei welcher Bildausschnitte der erfassten Abbildung der Leiterplatte mit entsprechenden Mustern verglichen werden. Alternativ ist es auch möglich, anhand der CAD-Daten ein synthetisches Bild der Oberfläche der Leiterplatte zu erstellen. Dieses synthetische Bild wird nachfolgend als CAD-Bild bezeichnet. Das mit dem bildgebenden Verfahren von der Leiterplatte erfasste Bild kann dann in seiner Gesamtheit mit dem CAD-Bild verglichen werden, wobei Abweichungen zwischen diesen beiden Bildern in der oben erläuterten Art und Weise analysiert werden, um die Form und/oder Art der entsprechenden Leiterplattentestpunkte zu bestimmen. Auch hierbei werden die Ausschnitte des Bildes, die vom CAD-Bild abweichen, mit entsprechenden Mustern verglichen.

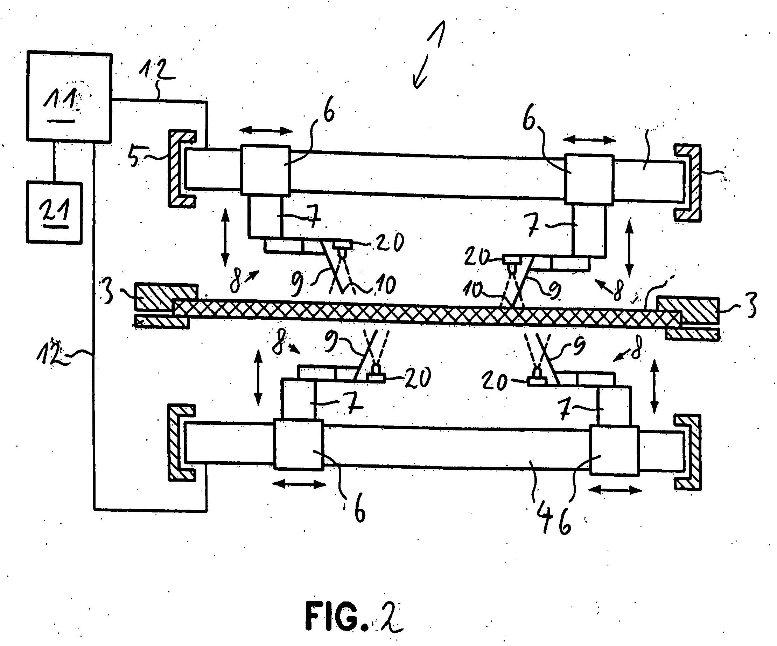

Figur 2 zeigt ein weiteres Ausführungsbeispiel einer erfindungsgemäßen Prüfvorrichtung 1, bei welcher jede Prüfsonde 8 mit einer Kamera 20 versehen ist, mit welcher die Oberfläche einer zu testenden Leiterplatte abgetastet werden kann. Über Leitungen 12 ist eine Steuereinrichtung 11 mit den Stellgliedern (Schlitten 6, Prüfköpfe 7) und den Sensoren (Kamera 20, Prüfnadel 9) elektrisch verbunden. An die Steuereinrichtung 11 ist eine kombinierte Bilderzeugungs-/Auswerteeinrichtung 21 angeschlossen. Der Aufbau dieser Prüfvorrichtung ist aus der WO 03/096037 bekannt, auf welche diesbezüglich verwiesen wird. Das erfindungsgemäße Verfahren wird bei dieser Prüfvorrichtung genau so angewandt, wie bei dem oben beschriebenen Ausführungsbeispiel, wobei die Oberfläche der Leiterplatte 2 mit den in die Prüfsonden 8 integrierten Kameras 20 erfasst wird.

Alternativ ist es auch möglich, die Oberfläche einer zu testenden Leiterplatte mit einer separaten Abtastvorrichtung, die unabhängig von der Prüfvorrichtung für Leiterplatten ausgebildet ist, abzutasten, das entsprechende Bild mit einem automatischen Bildanalyseverfahren zu analysieren und mit den CAD-Daten zu vergleichen, um in vorbestimmten Bereichen Abweichungen zu ermitteln. Hierzu kann ein handelsüblicher optischer Scanner verwendet werden, der ein Bild der Oberfläche der zu testenden Leiterplatte erzeugt, das an eine entsprechende Auswerteeinrichtung übermittelt wird.

Anstelle optischer Abtastverfahren können auch elektromechanische Abtastverfahren verwendet werden. Ein solches elektromechanisches Abtastverfahren ist zum Beispiel aus der DE 40 12 839 B4 bekannt, bei welchem Leiterstrukturen an der Oberfläche der zu testenden Leiterplatten mit derart eng beieinander liegenden Testpunkten abgetastet werden, dass aus den hiermit ermittelten elektrischen Signalen ein Bild der Oberfläche der Leiterplatte erzeugt werden kann. Aus der EP 0 989 409 A1 geht ein Verfahren hervor, bei welchem die Oberfläche einer zu testenden Leiterplatte mit einer Sonde abgestrichen wird, die eine Vielzahl von Kontaktelementen aufweist, die bürstenartig an der Sonde angeordnet sind, so dass mit einer sehr hohen Auflösung die Oberfläche der Leiterplatte elektrisch abgetastet wird. Eine solche Sonde wird auch als Kontaktbürste bezeichnet. Auch aus diesen Signalen kann ein Bild der Oberfläche der Leiterplatte erzeugt werden. Die derart elektromechanisch erzeugten Bilder können in gleicher Weise, wie bei den obigen Ausführungsbeispielen, analysiert und mit den CAD-Daten bzw. einem CAD-Bild verglichen werden.

Die vorbestimmten Bereiche der Leiterplatte, die mit dem bildgebenden Verfahren erfasst werden, können Teilbereiche der Leiterplatte oder auch die gesamte Oberfläche der Leiterplatte umfassen. Üblicherweise werden Leiterplatten mittels mehreren Masken hergestellt, mit welchen bei der Herstellung die Metallschichten belichtet werden. Die Masken bestimmen daher die Form der Leiterstruktur. Weiterhin gibt es Masken zum Belichten von Lötstopplack, der auf der Oberfläche der Leiterplatte aufgetragen wird und auch freiliegende Bereiche der Leiterstrukturen begrenzen und damit Leiterplattentestpunkte definieren kann. Es hat sich gezeigt, dass im Fall von Abweichungen gegenüber dem CAD-Daten diese Abweichungen gehäuft an Leiterplattentestpunkten auftreten, die mit einer oder einigen wenigen Masken hergestellt worden sind. Daher ist es zweckmäßig, mit dem erfindungsgemäßen Verfahren zumindest jeweils einen von einer jeden Maske definierten Leiterplattentestpunkt zu untersuchen. Hierzu werden zumindest die Bereiche einer zu testenden Leiterplatte mit dem bildgebenden Verfahren erfasst, die derartig definierte Leiterplattentestpunkte aufweisen.

### Bezugszeichenliste

- 1: Fingertester
- 2: Leiterplatte
- 3: Halterahmen
- 4: Traverse
- 5: Schiene
- 6: Schlitten
- 7: Prüfkopf
- 8: Prüfsonde
- 9: Prüfnadel
- 10: Prüfspitze
- 11: Steuereinrichtung
- 12: Leitung
- 13: Kamera
- 14: Bilderzeugungseinrichtung
- 15: Leitung
- 16: Auswerteeinrichtung
- 17: Leiterplattentestpunkt
- 18: Leiterbahn
- 19: Ausschnitt
- 20: Kamera
- 21: Bilderzeugungs-/Auswerteeinrichtung

## Patentansprüche

1. Verfahren zum Testen von unbestückten Leiterplatten, umfassend folgende Schritte:
- Erfassen vorbestimmter Bereiche einer zu testenden Leiterplatte (2) mit einem bildgebenden Verfahren,
- Ermitteln von Form und/oder Typ von in den vorbestimmten Bereichen liegenden Leiterplattentestpunkten mittels automatischer Bildanalyse,
- Vergleichen der ermittelten Form und/oder des ermittelten Typs der Leiterplattentestpunkte mit entsprechenden CAD-Daten der Leiterplatte (2) und Ermitteln von Abweichungen der zu testenden Leiterplatte (2) von den CAD-Daten, und
- Testen der Leiterplatte (2) mit einem Fingertester (1), wobei Prüffinger (7, 8) des Fingertesters nach Maßgabe der ermittelten Abweichungen angesteuert werden.

2. Verfahren nach Anspruch 1,
**dadurch gekennzeichnet,**
**dass** beim Erfassen mit dem bildgebenden Verfahren Bilddaten der vorbestimmten Bereiche der zu testenden Leiterplatte (2) erzeugt werden,
beim Ermitteln von Form und/oder Typ der Leiterplattentestpunkte in diesen Bilddaten zunächst Bildausschnitte (19) ermittelt werden, die jeweils einen oder eine vorbestimmte Gruppe von Leiterplattentestpunkten darstellen, und dann diese Bildausschnitte (19) mit vorgegebenen Mustern verglichen werden, wobei anhand des Mustervergleichs der Typ der Leiterplattentestpunkte ermittelt wird.

3. Verfahren nach Anspruch 2,
**dadurch gekennzeichnet,**
**dass** nach dem Ermitteln des Typs der Leiterplattentestpunkte die Form der Leiterplattentestpunkte durch Analysieren der entsprechenden Bildausschnitte (19) ermittelt wird.

4. Verfahren nach Anspruch 2 oder 3,
**dadurch gekennzeichnet,**
**dass** der Vergleich der Bildausschnitte (19) mit den Mustern mittels eines Korrelations-Verfahrens durchgeführt wird.

5. Verfahren nach einem der Ansprüche 1 bis 4,
**dadurch gekennzeichnet,**
**dass** anhand der ermittelten Abweichungen die CAD-Daten korrigiert werden (S5) und mit den korrigierten CAD-Daten ein Prüfprogramm zum Ansteuern der Prüffinger (7, 8) beim Testen der Leiterplatte (2) erstellt wird.

6. Verfahren nach einem der Ansprüche 1 bis 4,
**dadurch gekennzeichnet,**
**dass** anhand der ermittelten Abweichungen eine Korrekturdatei für ein Prüfprogramm erstellt wird, mit dem beim Testen der Leiterplatten (2) die Prüffinger (7, 8) angesteuert werden.

7. Verfahren nach einem der Ansprüche 1 bis 6,
**dadurch gekennzeichnet,**
**dass** als bildgebendes Verfahren ein optisches Verfahren, bei dem mit einem optischen Sensor (13, 20) die vorbestimmten Bereiche der zu testenden Leiterplatte (2) erfasst werden, verwendet wird.

8. Verfahren nach einem der Ansprüche 1 bis 6,
**dadurch gekennzeichnet,**
**dass** als bildgebendes Verfahren ein elektromechanisches Verfahren verwendet wird, bei welchen die Oberfläche der zu testenden Leiterplatte (2) mit einer derart hohen Auflösung elektrisch abgetastet wird, dass ein Bild der Oberfläche erzeugt wird.

9. Verfahren nach einem der Ansprüche 1 bis 8,
**dadurch gekennzeichnet,**
**dass** das Erfassen der vorbestimmten Bereiche im Fingertester (1) ausgeführt wird.

10. Verfahren nach einem der Ansprüche 1 bis 8,
**dadurch gekennzeichnet,**
**dass** das Erfassen der vorbestimmten Bereiche in einer vom Fingertester (1) unabhängigen Vorrichtung ausgeführt wird.

11. Verfahren nach einem der Ansprüche 1 bis 10,
**dadurch gekennzeichnet,**
**dass** zum Test von Leiterplatten (2), die mittels mehrerer Masken hergestellt worden sind, welche die Form der Leiterplattentestpunkte definieren, die vorbestimmten Bereiche, die mit dem bildgebenden Verfahren erfasst werden, zumindest einen von einer jeden Maske definierten Leiterplattentestpunkt umfassen.

12. Verfahren nach einem der Ansprüche 1 bis 10,
**dadurch gekennzeichnet,**
**dass** die vorbestimmten Bereiche, die mit dem bildgebenden Verfahren erfasst werden, alle Leiterplattentestpunkte umfassen.

13. Vorrichtung zum Ausführen des Verfahrens nach einem der Ansprüche 1 bis 12, umfassend
eine Einrichtung (13, 14, 20, 21) konfiguriert zum Erfassen vorbestimmter Bereiche einer zu testenden Leiterplatte (2) mit einem bildgebenden Verfahren, und
eine Auswerteeinrichtung (16, 21) konfiguriert
- zum Ermitteln von Form und/oder Typ von in den vorbestimmten Bereichen liegenden Leiterplattentestpunkten mittels automatischer Bildanalyse,
- zum Vergleichen der ermittelten Form und/oder des ermittelten Typs der Leiterplattentestpunkte mit entsprechenden CAD-Daten der Leiterplatte, und
- zum Ermitteln von Abweichungen der zu testenden Leiterplatte von den CAD-Daten.

14. Vorrichtung nach Anspruch 13,
**dadurch gekennzeichnet,**
**dass** die Auswerteeinrichtung (16, 21) zum Korrigieren der CAD-Daten ausgebildet ist.

15. Vorrichtung nach Anspruch 13 oder 14,
**dadurch gekennzeichnet,**
**dass** die Einrichtung zum Erfassen vorbestimmter Bereiche einer zu testenden Leiterplatte mit einem bildgebenden Verfahren einen optischen Sensor (13, 20) oder einen elektrischen Sensor mit mehreren Kontaktelementen aufweist.

## Claims

1. Method for the testing of non-componented circuit boards comprising the following steps:
- recording of predetermined areas of a circuit board (2) to be tested by an imaging process
- determination of the form and/or type of circuit board test points lying in the predetermined areas by means of automatic image analysis
- comparison of the determined form and/or the determined type of the circuit board test points with corresponding CAD data for the circuit board (2), and determination of deviations of the circuit board (2) to be tested from the CAD data, and
- testing of the circuit board (2) with a finger tester (1), in which test fingers (7, 8) of the finger tester are controlled on the basis of the deviations found.

2. Method according to claim 1,
**characterised in that**
in recording by the imaging process, image data of the predetermined areas of the circuit board (2) to be tested are produced, and firstly in determining the form and/or type of the circuit board test points, image details (19) are selected from these image data which in each case represent one or a predetermined group of circuit board test points, and then these image details (19) are compared with preset patterns and the type of circuit board test points is determined with the aid of this pattern comparison.

3. Method according to claim 2,
**characterised in that**
after determining the type of the circuit board test points, the form of the circuit board test points is determined through analysis of the relevant image details (19).

4. Method according to claim 2 or 3,
**characterised in that**
the comparison of the image details (19) with the patterns is made by a correlation method.

5. Method according to any of claims 1 to 4
**characterised in that**
with the aid of the deviations found, the CAD data are corrected (S5), and the corrected CAD data are used to create a test program for controlling the test fingers (7, 8) in testing the circuit board (2).

6. Method according to any of claims 1 to 4,
**characterised in that**
with the aid of the deviations found, a correction file for a test program is created and used for controlling the test fingers (7, 8) in testing the circuit board (2).

7. Method according to any of claims 1 to 6
**characterised in that**
an optical method, in which an optical sensor (13, 20) records the predetermined areas of the circuit board (2) to be tested, is used as the imaging method.

8. Method according to any of claims 1 to 6,
**characterised in that**
an electro-mechanical method, in which the surface of the circuit board (2) to be tested is scanned electrically at a sufficiently high resolution to produce an image of the surface, is used as the imaging method.

9. Method according to any of claims 1 to 8,
**characterised in that**
the recording of the predetermined areas is carried out in the finger tester (1).

10. Method according to any of claims 1 to 8,
**characterised in that**
the recording of the predetermined areas is carried out in a device which is independent of the finger tester (1).

11. Method according to any of claims 1 to 10,
**characterised in that**
for the testing of circuit boards (2) which have been made by means of several masks which define the form of the circuit board test points, the predetermined areas recorded by the imaging method cover at least one circuit board test point defined by each mask.

12. Method according to any of claims 1 to 10,
**characterised in that**
the predetermined areas recorded by the imaging method cover all circuit board test points.

13. Device for implementing the method according to any of claims 1 to 12, comprising
a unit (13, 14, 20, 21) for recording predetermined areas of a circuit board (2) to be tested by an imaging process, and an evaluation unit (16, 21)
- for determining the form and/or type of circuit board test points lying in the predetermined areas by means of automatic image analysis,
- for comparison of the determined form and/or the determined type of the circuit board test points with corresponding CAD data for the circuit board, and
- for determination of deviations on the circuit board to be tested from the CAD data.

14. Device according to claim 13,
**characterised in that**
the evaluation unit (16, 21) is designed for correlation of the CAD data.

15. Device according to claim 13 or 14,
**characterised in that**
the unit for recording predetermined areas of a circuit board to be tested using an imaging method has an optical sensor (13, 20), or an electrical sensor with several contact elements.

## Revendications

1. Procédé pour tester des cartes à circuits imprimés nues, comprenant les étapes suivantes :
- acquisition de zones prédéterminées d'une carte à circuits imprimés (2) à tester avec un procédé d'imagerie,
- détermination de la forme et/ou du type de points de test situés dans les zones prédéterminées sur la carte à circuits imprimés au moyen d'une analyse d'imagerie automatique,
- comparaison de la forme déterminée et/ou du type déterminé des points de test de la carte à circuits imprimés avec des données CAD correspondantes de la carte à circuits imprimés (2) et détermination d'écarts de la carte à circuits imprimés (2) à tester par rapport aux données CAD, et
- test de la carte à circuits imprimés (2) avec un dispositif de test à doigts (1), dans lequel les doigts de test (7, 8) du dispositif de test à doigts sont pilotés selon la mesure des écarts déterminés.

2. Procédé selon la revendication 1,
**caractérisé en ce que**,
lors de l'acquisition avec le procédé d'imagerie, on produit des données image des zones prédéterminées de la carte à circuit imprimé (2) à tester,
lors de la détermination de la forme et/ou du type des points de test de la carte à circuits imprimés on détermine tout d'abord dans ces données image des extraits d'images (19) qui représentent respectivement un point de test ou un groupe prédéterminé de points de test de la carte à circuits imprimés, et ensuite
ces extraits d'images (19) sont comparés à des motifs prédéterminés, et l'on détermine le type des points de test de la carte à circuits imprimés au moyen de la comparaison aux motifs.

3. Procédé selon la revendication 2,
**caractérisé en ce que**, après détermination du type des points de test de la carte à circuits imprimés, on détermine la forme des points de test de la carte à circuits imprimés par analyse des extraits d'images correspondants (19).

4. Procédé selon la revendication 2 ou 3,
**caractérisé en ce que** la comparaison des extraits d'images (19) avec les motifs est effectuée au moyen d'un processus de corrélation.

5. Procédé selon l'une des revendications 1 à 4,
**caractérisé en ce que** les données CAD sont corrigées (S5) au moyen des écarts déterminés, et un programme de contrôle destiné à piloter les doigts de test (7, 8) lors du test de la carte à circuits imprimés (2) est établi avec les données CAD corrigées.

6. Procédé selon l'une des revendications 1 à 4,
**caractérisé en ce qu'**un fichier de correction pour un programme de contrôle est établi au moyen des écarts déterminés, fichier au moyen duquel les doigts de test (7, 8) sont pilotés lors du test des cartes à circuits imprimés (2).

7. Procédé selon l'une des revendications 1 à 6,
**caractérisé en ce que** l'on utilise comme procédé d'imagerie un procédé optique au moyen duquel les zones prédéterminées de la carte à circuits (2) à tester sont acquises avec un capteur optique (13, 20).

8. Procédé selon l'une des revendications 1 à 6,
**caractérisé en ce que** l'on utilise comme procédé d'imagerie un procédé électromécanique dans lequel la surface de la carte à circuits imprimés (2) à tester est palpée de manière électrique avec une résolution aussi élevée que l'on engendre une image de la surface.

9. Procédé selon l'une des revendications 1 à 8,
**caractérisé en ce que** l'acquisition des zones prédéterminées est exécutée dans le dispositif de test à doigts (1).

10. Procédé selon l'une des revendications 1 à 8,
**caractérisé en ce que** l'acquisition des zones prédéterminées est exécutée dans un dispositif indépendant du dispositif de test à doigts (1).

11. Procédé selon l'une des revendications 1 à 10,
**caractérisé en ce que** pour le test de cartes à circuit imprimé (2) qui ont été produites au moyen de plusieurs masques qui définissent la forme des points de test de la carte à circuits imprimés, les zones prédéterminées qui sont acquises avec le procédé d'imagerie comprennent au moins un point de test sur la carte à circuits imprimés défini par chaque masque.

12. Procédé selon l'une des revendications 1 à 10,
**caractérisé en ce que** les zones prédéterminées qui sont acquises avec le procédé d'imagerie comprennent tous les points de test de la carte à circuits imprimés.

13. Dispositif pour la mise en oeuvre du procédé selon l'une des revendications 1 à 12, comprenant
un système (13, 14, 20, 21) configuré pour acquérir des zones prédéterminées d'une carte à circuits imprimés (2) à tester avec un procédé d'imagerie, et
un dispositif d'évaluation (16, 21) configuré
- pour déterminer la forme et/ou le type de points de test de la carte à circuits imprimés situés dans les zones prédéterminées, au moyen d'une analyse d'imagerie automatique,
- pour comparer la forme déterminée et/ou le type déterminé des points de test de la carte à circuits imprimés avec des données CAD correspondantes de la carte à circuits imprimés, et
- pour déterminer des écarts de la carte à circuits imprimés à tester par rapport aux données CAD.

14. Dispositif selon la revendication 13,
**caractérisé en ce que** le dispositif d'évaluation (16, 21) est réalisé pour corriger les données CAD.

15. Dispositif selon la revendication 13 ou 14,
**caractérisé en ce que** le système pour acquérir des zones prédéterminées d'une carte à circuits imprimés à tester dans un procédé d'imagerie comprend un capteur optique (13, 20) ou un capteur électrique avec plusieurs éléments de contact.
